(19) Europäisches Patentamt
European Patent Office
Office européen des brevets

(11) **EP 3 524 356 A1**

(12) **EUROPEAN PATENT APPLICATION**

(43) Date of publication:
**14.08.2019  Bulletin 2019/33**

(51) Int Cl.:
**B03C 1/033** *(2006.01)*    **G01R 33/12** *(2006.01)*
**G01N 27/74** *(2006.01)*    **G01N 11/10** *(2006.01)*

(21) Application number: **18156202.6**

(22) Date of filing: **11.02.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(71) Applicant: **Universität Zürich
8006 Zürich (CH)**

(72) Inventor: **The designation of the inventor has not
yet been filed**

(74) Representative: **Schmauder & Partner AG
Patent- & Markenanwälte VSP
Zwängiweg 7
8038 Zürich (CH)**

(54) **DEVICES FOR APPLYING FORCES TO FERROMAGNETIC PROBES AT BOTH CELLULAR AND TISSUE LEVELS**

(57)    An electromagnetic device (2) for applying forces to ferromagnetic probes at both cellular and tissue levels, comprises an elongated magnetic core member (4) made of a ferromagnetic material, a solenoid member (6) comprising a plurality of coil windings (8) arranged around the core member, and core cooling means (10) for cooling the core member and solenoid cooling means (12) for cooling the solenoid member when an electrical current is driven therethrough. In order to improve performance, the core member comprises a substantially cylindrical main region (14) defining a central longitudinal axis (A) and further comprises a tapered end region (16) with an asymmetrically tapered shape having a tip region (18) that is laterally displaced from the central longitudinal axis (A), the tip region having an average cross-sectional diameter (Dt) of 0.5 to 2 mm. The solenoid member further comprises a shell element made (20) of a thermally conductive material and forming a support for the coil windings, the shell element surrounding a first portion of the main region of the core member, the core cooling means comprise a water-coolable cooling block (22) thermally contacted to a second portion of the main region of the core member, and the solenoid cooling means comprise a plurality of cooling fins (24) radially protruding from the shell element and configured for air cooling by means of an external airstream. A magnetic tweezer device for applying forces to ferromagnetic probes at both cellular and tissue levels, comprises at least one electromagnetic device and further comprises power supply means for driving an electrical current through the solenoid member, a holder system comprising a sample support (26) and means for adjustably holding each electromagnetic device in a predetermined position and orientation with respect to the sample support, and means (28) for observing a sample (30) arranged on the sample support.

Fig. 1

## Description

<u>Field of the invention</u>

The present invention relates to an electromagnetic device for applying forces to ferromagnetic probes at both cellular and tissue levels. It further relates to a magnetic tweezer device comprising at least one such electromagnetic device. Still further, it relates to a method of applying forces to a ferromagnetic probe at a cellular or tissue level by means of such a magnetic tweezer device.

<u>Background of the invention</u>

The study of microrheological properties of living organisms is often limited due to the disruptive nature of the correspondingly necessary mechanical manipulation. However, by using minimally invasive methods such as magnetic tweezers, it is possible to locally determine cytoplasmic viscoelasticity inside embryos. Magnetic tweezers apply an external magnetic field to generate a force on superparamagnetic beads. Magnetic tweezers are a robust force spectroscopy technique employed in several fields to manipulate single molecules (1), as magnetic probes inside live cells (2), to investigate mechanical properties of biological macromolecules (3), (4), (5), (6), (7) and cancer cells (8), to measure biopolymer and single cell microrheology (9), (10), (11), (12) to study intracellular applications (13) and structure-mechanics relationship in biopolymer network (14), as well as force regulated processes in developing embryos (15), (16), (17). The large presence of magnetic tweezers found in the literature demonstrates the usefulness of the method that compared to other powerful techniques, like optical tweezers and atomic force microscopy, presents several advantages. These include: no photo-damage, more selectivity in trapping the probe, employment of force as large as hundreds of pN and the capability of decoupling the imaging from the force paths, which allows the use of any objective lens independently of its numerical aperture. Although magnetic tweezers have become a popular biophysical tool also thanks to their versatility in applying both torques and forces, there are still several limitations in existing solutions. The main drawbacks include: the limitation of the time response of the system and the introduction of mechanical noise by moving permanent magnets (14); the constraint of using at least two electromagnets to guarantee constant forces over the area of interest (13); the constraint in employing long working distance objectives (9), (17) and the restriction in getting high forces at long distances from the electromagnet (9), even producing high power (17). The necessarily short distance between bead and magnet, imposed by the fact that pN forces can be obtained only close to the magnetic tip, makes present setups incompatible with closed chamber design for live cell imaging and also limit the distance over which the sample can be investigated. Moreover, for bead-core distances of only a few micrometers a sophisticated feedback force control is necessary to ensure an accurate constant force control. The bead movement towards the magnet leads to a steeply increasing force. For bead-core distances of more than 50 $\mu$m, the nonlinearity of the force-distance relationship is instead little pronounced.

For example, in order to investigate the microrheology properties of early Drosophila embryos to understand how a robust and reproducible syncytial development occurs, it would be desirable to have a magnetic tweezers setup that overcomes the existing limitations and is optimized to exert high constant forces (hundreds of pN) over extended region (> 100$\mu$m) from the magnetic tip to explore unimpeded the entire inside of fly embryos. A fly embryo is about 250$\mu$m in width and 500$\mu$m in length. A magnetic tweezers setup with the desired properties would not be limited in applying forces at the periphery of the embryo; rather it would be able to exert conspicuous forces also in the middle of the embryo, at a distance of about 120$\mu$m from the magnetic tip.

<u>*References*</u>

1 Lipfert, J.,Hao, X.,Dekker, N.H. "Quantitative Modeling and Optimization of Magnetic Tweezers", Biophysical Journal, 96, 5040 (2009).

2 De Vries, A.H.B., Krenn, B.E., van Driel,R., Kanger, J.S. "Micro Magnetic Tweezers for Nanomanipulation Inside Live Cells", Biophysical Journal, 88, 2137 (2005).

3 Gosse, C., Croquette, V. "Magnetic Tweezers: Micromanipulation and Force Measurement at the Molecular Level", Biophysical Journal, 82, 3314 (2002).

4 Vilfan, I.D., Lipfert, J., Koster, D.A., Lemay, S.G., Dekker, N.H. "Magnetic Tweezers for Single-Molecule Experiments", Handbook of Single-Molecule Biophysics, 371 (2009).

5 Lipfert, J., Koster, D.A., Vilfan, I.D., Hage, S., Dekker, N.H. "Single-Molecule Magnetic Tweezers Studies of Type IB Topoisomerases", Methods in Molecular Biology, 582, 71 (2009).

6 Kilinc, D, Lee, G.U. "Advances in magnetic tweezers for single molecule and cell biophysics", Integr. Biol., 6, 27 (2014).

7 Swaminathan, V., Mythreye, K., O'Brien2, E.T., Berchuck, A.Blobe, G.C., Richard Superfine, R. "Mechanical Stiffness Grades Metastatic Potential in Patient Tumor Cells and in Cancer Cell Lines", American Association for Cancer Research 71 (15), 5045 (2011).

8 Kollmannsberger, P., Fabry, B. "High-force magnetic tweezers with force feedback for biological applications", Review of Scientific Instruments, 78, 114301 (2007).

9 Bausch, A.R., Moller, W., Sackmann, E. "Measurement of Local Viscoelasticity and Forces in Living Cells by Magnetic Tweezers", Biophysical Journal, 76, 573 (1999).

10 Hoffman, B.D., Crocker, J.C. "Cell mechanics: Dissecting the Physical Responses of Cells to Force", Annu. Rev. Biomed. Eng.11, 259 (2009).

11 Hosu, B.G., Jakab, K., Banki, P., Toth, F.I., Forgacs, G. "Magnetic tweezers for intracellular applications", Review of Scinetific Instruments, 74, 9 (2003).

12 Yang, Y., Lin, J., Meschewski, R., Watson, E., Valentine, M.T. "Portable magnetic tweezers device enables visualization of the three-dimensional microscale deformation of soft biological materials", Reports, 51 (11), 29 (2011).

13 Desprat, N., Willy Supatto, W., Pouille, P.A.,Beaurepaire, E.,Farge, E. "Tissue Deformation Modulates Twist Expression to Determine Anterior Midgut Differentiation in Drosophila Embryos", Developmental Cell 15, 470 (2008).

14 Weber, G.F., Maureen A. Bjerke, M.A., DeSimone, D.W. A "Mechanoresponsive Cadherin-Keratin Complex Directs Polarized Protrusive Behavior and Collective Cell Migration", Dev Cell. , 17-22, 104 (2012).

15 Doubrovinskia, K., Swana, M., Polyakova, O., Wieschausa, E.F. "Measurement of cortical elasticity in Drosophila melanogaster embryos using ferrofluids", PNAS, 114, 1051 (2017).

16 Bijamov, A., Shubitidze,F., Oliver,P.M., Vezenov, D.V. "Quantitative modeling of forces in electromagnetic tweezers", J. of App. Physics, 108, 104701 (2010).

17 Tanase, M., Biais, N., Sheetz, M. Methods in Cell Biology. "Magnetic Tweezers in Cell Biology", Elsevier, 83, 473 (2007).

Summary of the invention

In view of the above, it is an object of the present invention to provide improved means for applying forces to ferromagnetic probes at both cellular and tissue levels.

Therefore, according to one aspect of the invention, an electromagnetic device for applying forces to ferromagnetic probes at both cellular and tissue levels, comprises an elongated magnetic core member made of a ferromagnetic material, a solenoid member comprising a plurality of coil windings arranged around the core member, and core cooling means for cooling the core member and solenoid cooling means for cooling the solenoid member when an electrical current is driven therethrough. The core member comprises a substantially cylindrical main region defining a central longitudinal axis and further comprises a tapered end region with an asymmetrically tapered shape having a tip region that is laterally displaced from the central longitudinal axis, the tip region having an average cross sectional diameter of 0.5 to 2 mm, the solenoid member further comprises a shell element made of a thermally conductive material and forming a support for the coil windings, the shell element surrounding a first portion of the main region of the core member, the core cooling means comprise a water-coolable cooling block thermally contacted to a second portion of the main region of the core member, and the solenoid cooling means comprise a plurality of cooling fins radially protruding from the shell element and configured for air cooling by means of an external airstream. Advantageously, the solenoid cooling means further comprise a blower device for blowing cooling air along the cooling fins.

The term "average cross-sectional diameter" of the tip region shall be understood as the average diameter of the region where the tapering shape reaches an end. In the case of a substantially planar tip region, the average cross-sectional diameter will be the average diameter of the planar tip region. In the case of a cup shaped tip region, where the tip has a substantially hemispheric shape, the average cross-sectional diameter will correspond to the hemisphere diameter.

In many applications where the core member is arranged horizontally with its central longitudinal axis above a sample region, the term "laterally displaced" is equivalent to "below", i.e. the tip region is displaced downwards with respect to the central longitudinal axis.

The asymmetrically tapered shape having a tip region that is laterally displaced from the core central longitudinal axis not only allows placing the core member in close proximity to a sample resting on a surface, but it also allows for the possibility of employing any objective lens, from immersion up to long working distance, to image the sample. These advantageous properties are further improved in combination with the provision of a moderately large tip size of 0.5 to 2mm, and a short design of the solenoid member. The moderately large size of the tip allows for a higher magnetic saturation point compared to other sizes of the same tip material. As is generally known, the magnetic field intensity does not depend on the length of the core member but on the length of the solenoid member disposed on the core member. For a given number of turns, the solenoid member should be as short as possible, because the magnetic field scales as

$$B = N(\text{number of turns}) \; I \; (\text{current}) \; / \; L \; (\text{length of the coil}).$$

Accordingly, the electromagnetic device according to the above aspect is suitable for any applications which require applying large static forces of hundreds of pN to ferromagnetic probes at a cellular and/or tissue level. Such probes can be, in particular, micron-sized beads which are located at a distance in excess of $100\mu$m from the magnetic tip.

In particular, the electromagnetic device according to the above aspect is suitable as a key component of a magnetic tweezer device.

Therefore, according to another aspect of the invention, a magnetic tweezer device for applying forces to ferromagnetic probes at both cellular and tissue levels comprises at least one electromagnetic device as defined above and further comprises power supply means for driving an electrical current through the solenoid member, a holder system comprising a sample support and means for adjustably holding each electromagnetic device in a predetermined position and orientation with respect to the sample support, and means for observing a sample arranged on the sample support.

By virtue of the asymmetrically tapered shape of the end region of the core member, it is possible to have observing means with any objective lens from immersion to long working distance. The advantage of using immersion objective lenses, usually prevented by existing magnetic tweezers solutions, is the higher resolution that can be obtained in the image, as this depends on the numerical aperture of the lens and high numerical aperture objective lenses have to work in contact with the sample.

According to a further aspect of the invention, a method of applying forces to a ferromagnetic probe at a cellular or tissue level by means of a magnetic tweezer device as defined above comprises driving an electrical current through at least one solenoid member so as to generate a magnetic field interacting with a ferromagnetic probe embedded in a sample arranged on the sample support.

As generally known in the technical field of electromagnets, the coil windings of a solenoid member are made up with an electrically conductive wire provided with an insulating outer layer. Such wire is also known as "magnet wire" or "enameled wire".

Moreover, the skilled person will understand that the dimensions of the above defined device may be varied in a certain range. Typically, the core member will have a diameter Dc in the range of 5mm to 20mm, particularly about 10mm, a length Lc of the cylindrical main region in the range of 50mm to 100mm, particularly of about 65mm, and a length Le of the tapered end region of 10mm to 30mm, particularly about 20mm. Depending on the specific application, the tip region typically has a diameter Dt of about 0.5 to 2mm, particularly about 1 mm.

It should be emphasized that any geometric properties that will be mentioned in relation to the present invention shall not be understood in the strict mathematical sense. Rather than that, such properties shall be understood with a degree of accuracy or tolerance that corresponds to the type of structure, material and purpose of the involved parts. For example, the accuracy of describing the surface of a cylindrical or conical part will depend on the roughness and stiffness of the surface. The skilled person is expected to know how strictly a geometric property shall be interpreted in a given context.

Advantageous embodiments are defined in the dependent claims and in the description further below.

In principle, various designs of the cooling fins could be adopted. According to an advantageous embodiment (claim 2), the cooling fins are configured as discs which are stacked along the central longitudinal axis, each pair of adjacent discs defining a gap region containing coil windings of the solenoid member. In this manner, the cooling fins act both as spacer elements for the coil windings and as cooling surfaces. Advantageously, each fin is provided with an opening for passing coil wire from one gap region to the next. Preferably, the openings are configured as radial slots starting from the outer circumference of the respective disc. Moreover, it is advantageous to provide the cooling fins with a black surface so as to enhance radiative heat dissipation.

It is important to establish a good thermal contact between the water-coolable cooling block and the core member. Therefore, it is advantageous (claim 3) to apply a heat conductive contact medium in the relevant contact region, i.e. the second portion of the main region of the core member. Appropriate contact media are generally available, notably as heat conductive paste. A good thermal contact allows keeping the thickness of the cooling block, i.e. its extension in axial direction in a reasonable range. Accordingly, the second portion of the main region of the core member, which is preferably located between the first portion and the tapered region, can be kept reasonably short. It may also be advantageous to apply a heat conductive paste between coil windings.

The skilled person will be able to select appropriate materials for the various components forming the devices of the present invention. In particular, the coated wire forming the coil windings is preferably made of copper or silver. According to an advantageous embodiment (claim 4), the coil windings are made of insulation coated silver wire. The use of silver wire instead of copper wire is advantageous both because of its superior electrical conductivity and because of its superior heat conductivity. This is translated into a 7% decrease in the heat energy that must be dissipated. Similarly, various ferromagnetic materials such as e.g. iron or so-called "mu metal" are known to be suitable for making cores of electromagnets. According to a further advantageous embodiment (claim 5), the ferromagnetic material of the core member is iron, which stands out for its higher saturation point. Still further, various materials are known which are affordable, provide good heat conductivity and are suitable for machining. Therefore, according to yet another advantageous embodiment (claim 6), the shell element is made of aluminum or silver. Aluminum has excellent mechanical and thermal properties and a comparatively low cost. Silver is more expensive but has superior ductility and thermal conductivity, which allows adopting thinner fins. Thinner fins means that he number of fins for a given length of the coil can be increased, which translates in an improved heat dissipation.

While various shapes of the tapered end region could be suitable for the purposes of the present invention, it has been found advantageous (claim 7) to provide the tapered end region with a cross sectional area which monotonically decreases in longitudinal direction towards the tip region. According to a particularly advantageous embodiment (claim 8), the tapered end region has one generatrix line lying in the outer surface of the cylindrical main region. In other words, there is one straight line lying in the outer surface of the core member which is oriented parallel to the central longitudinal axis and which extends all the way to the tip region without discontinuity, i.e. without a kink at the transition between cylindrical main region and tapered end region. Such a shape allows placing the core member on a planar surface with the before mentioned generatrix contacting the surface, which will bring the laterally displaced tip region in closest proximity to the surface.

The detailed shape of the tip region has an influence on the magnetic field distribution in the vicinity of the tip and thus may be selected in accordance with specific requirements. According to one embodiment (claim 9), the tip region has a substantially planar tip face or a cup-shaped end.

According to an advantageous embodiment of the magnetic tweezer device (claim 11), the observing means comprise an optical microscope arrangement.

According to a particularly advantageous embodiment of the magnetic tweezer device (claim 12), the sample support defines a substantially planar sample surface and each core member is rotationally oriented about its central longitudinal axis in such manner as to minimize displacement of the tip region from the sample surface.

According to one embodiment (claim 13), the magnetic tweezer device comprises a single electromagnetic device. Such a configuration is particularly suitable for microrheology investigations and to study the forces involved during biological processes. According to another embodiment (claim 14), the magnetic tweezer device comprises a pair of electromagnetic devices arranged in mutually mirrored orientation with the respective tip regions facing towards each other and with respective distal end regions of the core members being connected by a ferromagnetic bar member so as to form a closed magnetic circuit. It has been found that closing the magnetic circuit in this manner leads to a 1.5-fold increase in the resulting magnetic field between the two tips. A mutually mirrored configuration is necessary for a 2D bead displacement and recommended to exert large forces for the study of force-regulated processes.

Magnetic beads have been injected inside embryos and used as probes for the surrounding environment. Viscoelastic properties of the environment of the beads have been evaluated from the analysis of the recorded trajectory of the particles.

Brief description of the drawings

The above mentioned and other features and objects of this invention and the manner of achieving them will become more apparent and this invention itself will be better understood by reference to the following description of various embodiments of this invention taken in conjunction with the accompanying drawings, wherein are shown:

Fig. 1:     a schematic sectional view of an embodiment of the electromagnetic device;

Fig. 2:     a longitudinal sectional view of a core member;

Fig. 3     a front view of the core member of Fig. 2;

Figs. 4 to 7     various views of an embodiment of a magnetic tweezers device;

Fig. 8     a side elevational view (a) and a front view (b) of a shell element;

Fig. 9     various components of a water coolable core cooling device;

Fig. 10     force calibration curves of 2.8 $\mu$m Dyna-beads for different electrical currents; and

Fig. 11         a comparison of saturation curves of various ferromagnetic cores.

Detailed description of the invention

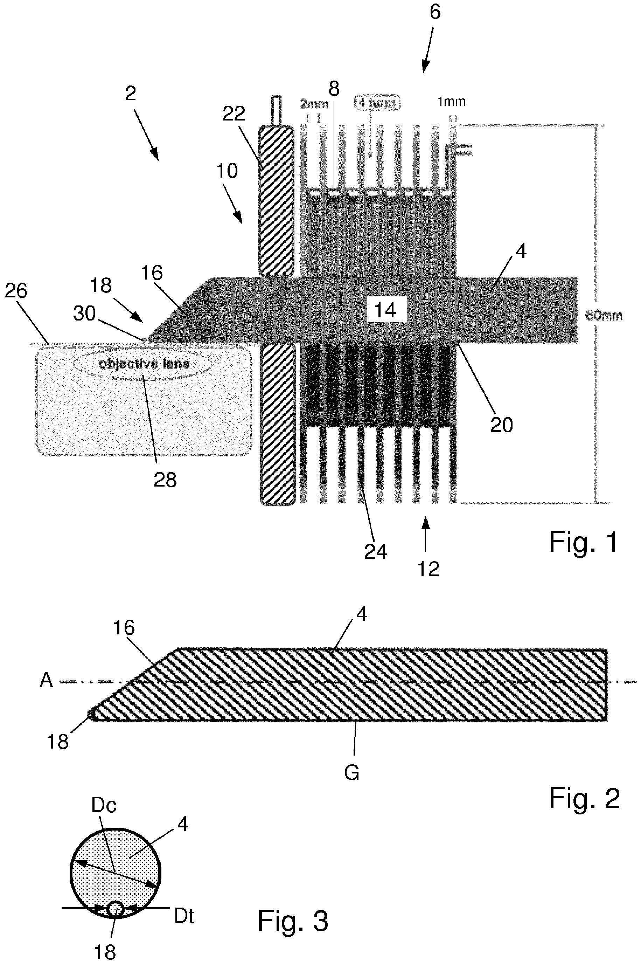

An embodiment of the electromagnetic device 2 is schematically shown in Figs. 1 to 3. The device comprises an elongated magnetic core member 4 made of a ferromagnetic material, a solenoid member 6 comprising a plurality of coil windings 8 arranged around the core member, and core cooling means 10 for cooling the core member and solenoid cooling means 12 for cooling the solenoid member. The core member comprises a substantially cylindrical main region 14 defining a central longitudinal axis A and it further comprises a tapered end region 16 with an asymmetrically tapered shape having a tip region 18 that is laterally displaced from the central longitudinal axis A. The solenoid member 6 further comprises a shell element 20 made of a thermally conductive material which forms a support for the coil windings 8. The shell element 20 surrounding a first portion of the main region of the core member. The core cooling means 10 comprise a water-coolable cooling block 22 thermally contacted to a second portion of the main region of the core member. The solenoid cooling means 12 comprise a plurality of cooling fins 24 radially protruding from a central part of the shell element and configured for air cooling by means of an external airstream.

Fig. 1 shows the electromagnetic device arranged in proximity of a sample support 26 configured as a planar microscopy slide and parts of a sample observation system comprising an objective lens 28 located underneath the microscopy slide. Also shown is a sample 30 which is understood to contain a ferromagnetic probe embedded therein.

As particularly shown in Figs. 2 and 3, the tapered end region has a cross sectional area which monotonically decreases in longitudinal direction towards the tip region. The tapered end region has one generatrix line G lying in the outer surface of the cylindrical main region.

In the example shown, the core member has a diameter Dc=10mm, a length of the cylindrical main region Lc=65mm, and a length of the tapered end region Le=20mm. The tip region has a diameter Dt=1 mm.

Example

The following is a description of an embodiment of the invention. The acronym "CAARMA" for "Computer-Aided-Ample-Range-Magnetic-Apparatus" will be used.

*Electromagnets*

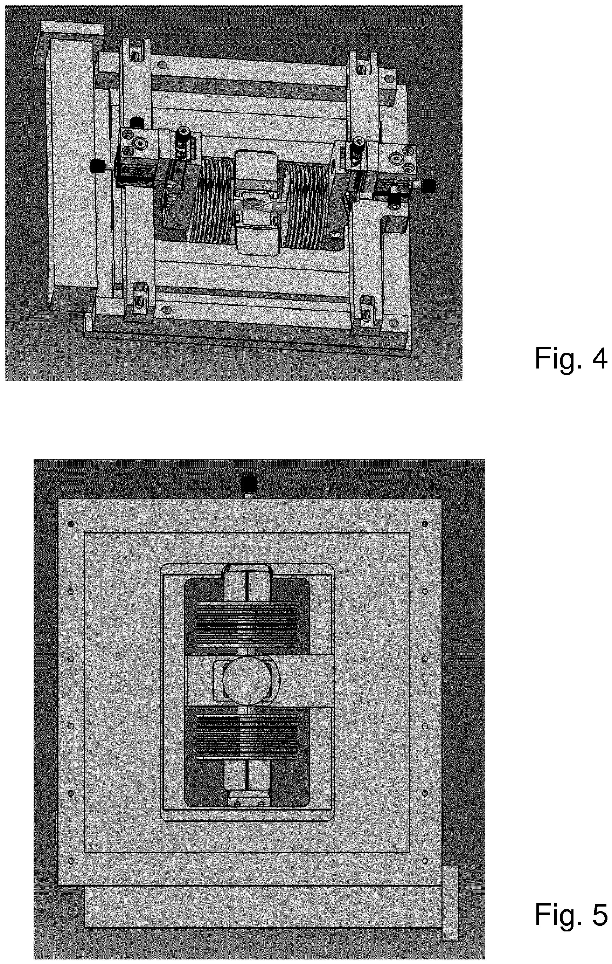

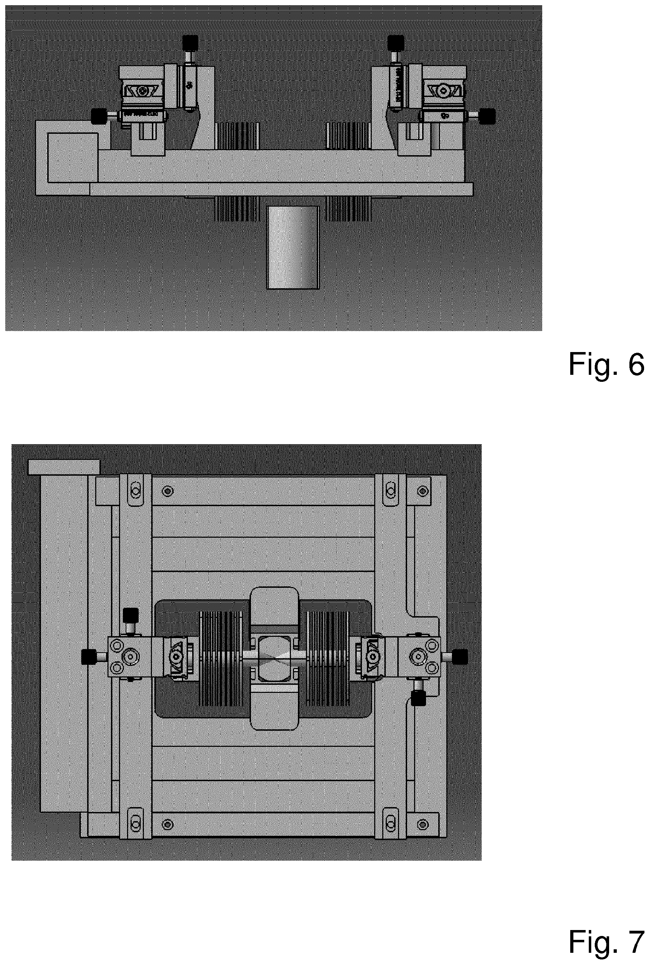

CAARMA is composed of a single or a pair of electromagnets sitting on a customized aluminum frame (23 cm x 22 cm) that makes the apparatus portable and easily fixable into commercial microscopes, Fig. 4 (CAARMA complete frame as mounted into a standard commercial confocal microscope), Fig. 5 (bottom view of CAARMA), Fig. 6 (side view of CAARMA), Fig. 7 (top view of CAARMA). Each electromagnet is fixed to a dedicated aluminum holder that in turns is clamped to a manual non-magnetic translational stage (from Thorlabs) to adjust the position of the two cores relative to the sample under investigation. It is contemplated to adopt a motorized translation stage in future implementations. A single electromagnet configuration is more appropriate for microrheology investigation and to study the forces involved during biological processes; while a pair of electromagnets is necessary for a 2D bead displacement and recommended to exert large forces for the study of force-regulated processes.

Each electromagnet employed in CAARMA device consists of a solenoid with 904 windings of 0.5 mm copper wire wrapped around a cylindrical aluminum shell (45 mm in total length). The length of the solenoid coil is 25 mm. Each coil has a resistance of 5.4 Ohm and is powered by a power supply with current values ranging from 0.1 to 5 A. The magnitude of the force produced by the electromagnet is proportional to the current intensity flowing in the coil up to the saturation of the core material. To guarantee reasonably high forces, while minimizing heating of the electromagnet, we suggest a current value of 3.5 A for experiments in bio samples.

Cooling system

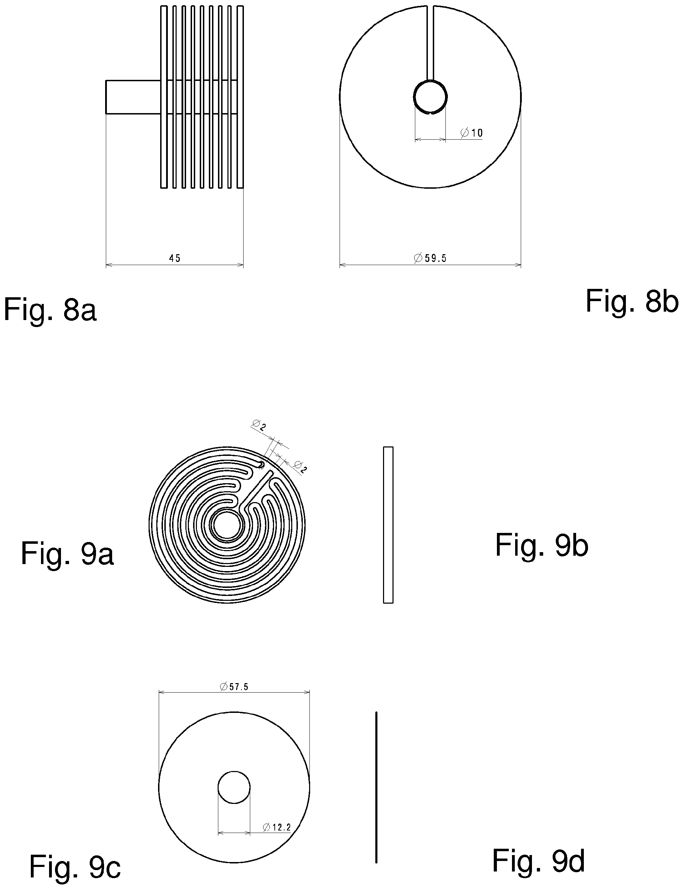

Working at 3.5 A and using a voltage of 19 V, we have to dissipate about 66 W. An increase in temperature due to large currents can damage the coil and negatively affects the magnetic properties of the core, decreases the amplitude and the gradient of the magnetic field and transfers heat to the biological sample affecting the experimental results. Therefore, to dissipate heat we combined two different cooling systems to protect both the coil and the core. To dissipate the heat produced by the current into the coil we designed nine black aluminum fins that sprout directly from the aluminum shell. Fins are 1 mm thick (except the first and the last that are 2 mm) and spaced by 2mm, Figs. 8a and 8b. We placed in front of these fins a fan with a funnel to direct the cold air exactly against the coil without blowing on the sample to avoid vibrations. In this way each fin is able to dissipate about 2.5 W while supplying 3.5 A to the coil. Otherwise, to dissipate the heat transferred from the coil to the core we designed a copper disc 4 mm thick and 59.5 mm in diameter (Figs. 9a-d) with a coil inside in which we let circulate water cooled by a refrigerator set at a temperature of 15°C. The coil has been designed to cover the maximum surface of the disc to increase heat exchange. Furthermore, we used a heat conductive paste to fill empty spaces between cooling unit and electromagnet to enhance the efficiency of the cooling. The efficiency of our cooling disc is superior to standard water-cooling solution consisting of a silicone or copper tube wrapped around the coil with circulating cold water inside.

Combining the air cooling with the water cooling it is possible to work with CAARMA for minutes with a pretty stable temperature. We stabilized the working temperature around 23°C as this was ideal for fly embryos used in our experiments. By changing the setting in the refrigerator is possible to adjust the working temperature according to the requirements of the experiments.

*Magnetic core*

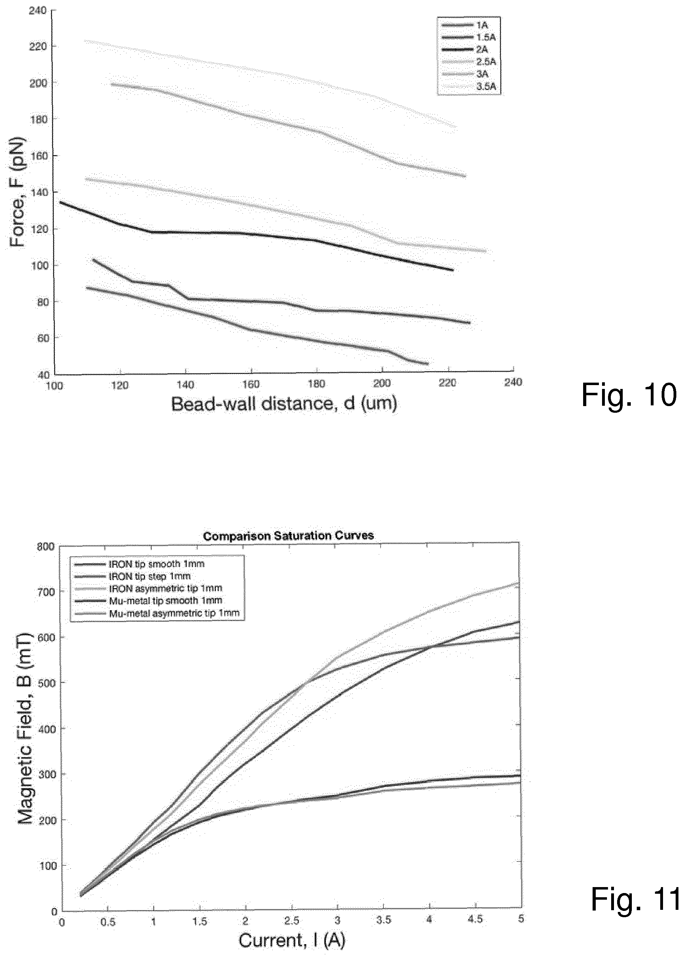

To increase the magnetic field strength, we placed a ferromagnetic core inside the electromagnet. The aluminum shell, from which sprout the cooling fins, houses this exchangeable cylindrical core. The design allows easy replacement of cores by simply sliding them into the electromagnet. For the material of the core we have chosen ARM-CO iron due to its large saturation magnetization. The diameter and length of the core are matched to the coil parameters, i.e. a diameter of 10 mm and a length of 65 mm. To get high magnetic forces a steep field gradient is required, therefore we tapered one end of the core giving it the shape of the nose of an airplane to also assure high forces over extended distances (hundreds of $\mu$m). The length of the tip coming out of the aluminum shell is 19.5 mm. The asymmetric profile of the resulting core has a flat base useful to get near to the sample on the coverslip, and a convergent profile on the top part that guarantees a high magnetic flux gradient in the area of interest. The numerous advantages in using an asymmetric core profile include: the possibility to employ a short working distance objective lens, as the latter can be moved unimpeded underneath the glass cover slip while the magnetic tip lies over the glass next to the embryo; the capability of applying horizontal forces perpendicular to the optical axis, that reveal themselves very convenient for tracking analysis as no other components must be considered and a standard 2D microscope is sufficient for beads motion analysis; and the capability of exerting almost constant forces over extended distances (about 100 $\mu$m) thanks to both the special asymmetric shape of the tip and the big cross section (1 mm) of the tip. The first allows to work at long bead-core distances, where the nonlinearity of the force-distance relationship is little pronounced; while the big cross section of the tip generates a slowly decreasing magnetic field gradient compared to existing solutions in which the tip size is usually one hundred times smaller and therefore the non-linearity of the force-distance relationship is substantial and requires a sophisticated active feedback control of the force. Using a ferromagnetic core inside the coil, a magnetic flux density gradient of 1100 T/m is achieved in the vicinity of the sample, which then exerts a force of 220 pN on 2.8 $\mu$m superparamagnetic beads (Dyna-beads, Thermo Fisher Scientific) at a distance of 110 $\mu$m from the magnetic tip, providing a current of 3.5 A to the coil, Fig. 10. The remnant field of the iron core, measured after switching off a current of 3.5 A in the coil and using a Hall-probe in contact with the magnetic tip, is of 1.2 mT that, for a produced magnetic field of 600 mT, corresponds to a 0.2% remnant magnetic field. The saturation curves of various ferromagnetic cores are shown in Fig. 11.

*Sample holder*

Between the two electromagnets an aluminum holder, 30 mm width and 90 mm long, holds a cover slide in the grooved compartment in its center. The cover slide is fixed into the holder by clamping two plastic bars at the shorter ends of the cover slide.

*Function generator to control the electromagnets*

To be able to switch the electromagnets between on and off states and to pulse the magnetic field with defined frequencies, we added a pulse generator controlling the power supplies. The pulse generator consists of a driving circuit working at low current (20 mA), coupled to a power circuit via two solid-state relays. It has a switch with three positions: "off" means no output, "on" works in continuous mode, and "pulse" provides predefined pulse trains of square waves. The pulse length can be easily adjusted by rotating a knob that changes the period of the square wave from 8ms up to 4.8s. The interval between pulses is fixed by a duty cycle of 50%.

**Claims**

**1.** An electromagnetic device (2) for applying forces to ferromagnetic probes at both cellular and tissue levels, comprising:

an elongated magnetic core member (4) made of a ferromagnetic material,

a solenoid member (6) comprising a plurality of coil windings (8) arranged around the core member, and

core cooling means (10) for cooling the core member and solenoid cooling means (12) for cooling the solenoid member when an electrical current is driven therethrough,

**characterized in that**

the core member comprises a substantially cylindrical main region (14) defining a central longitudinal axis (A) and further comprises a tapered end region (16) with an asymmetrically tapered shape having a tip region (18) that is laterally displaced from the central longitudinal axis (A), the tip region having an average cross-sectional diameter (Dt) of 0.5 to 2 mm,

the solenoid member further comprises a shell element made (20) of a thermally conductive material and forming a support for the coil windings, the shell element surrounding a first portion of the main region of the core member,

the core cooling means comprise a water-coolable cooling block (22) thermally contacted to a second portion of the main region of the core member, and

the solenoid cooling means comprise a plurality of cooling fins (24) radially protruding from the shell element and configured for air cooling by means of an external airstream.

2. The electromagnetic device according to claim 1, wherein the cooling fins are configured as discs which are stacked along the central longitudinal axis, each pair of adjacent discs defining a gap region containing coil windings of the solenoid member.

3. The electromagnetic device according to claim 1 or 2, wherein the thermal contact of the water-coolable cooling block and the core member is provided by a heat conductive contact medium.

4. The electromagnetic device according to one of claims 1 to 3, wherein the coil windings are made of insulation coated silver wire.

5. The electromagnetic device according to one of claims 1 to 4, wherein the ferromagnetic material of the core member is iron.

6. The electromagnetic device according to one of claims 1 to 5, wherein the shell element is made of aluminum or silver.

7. The electromagnetic device according to one of claims 1 to 6, wherein the tapered end region has a cross sectional area which monotonically decreases in longitudinal direction towards the tip region.

8. The electromagnetic device according to claim 7, wherein the tapered end region has one generatrix line G) lying in the outer surface of the cylindrical main region.

9. The electromagnetic device according to claim 7 or 8, wherein the tip region has a cup-shaped end.

10. A magnetic tweezer device for applying forces to ferromagnetic probes at both cellular and tissue levels, comprising at least one electromagnetic device according to claim 1, and further comprising:

power supply means for driving an electrical current through the solenoid member, a holder system comprising a sample support (26) and means for adjustably holding each electromagnetic device in a predetermined position and orientation with respect to the sample support, and

means (28) for observing a sample (30) arranged on the sample support.

11. The magnetic tweezer device according to claim 10, wherein the observing means comprise an optical microscope arrangement.

12. The magnetic tweezer device according to claim 10 or 11, wherein the sample support defines a substantially planar sample surface and wherein each core member is rotationally oriented about its central longitudinal axis in such manner as to minimize displacement of the tip region from the sample surface.

13. The magnetic tweezer device according to one of claims 10 to 12, comprising a single electromagnetic device.

14. The magnetic tweezer device according to one of claims 10 to 12, comprising a pair of electromagnetic devices arranged in mutually mirrored orientation with the respective tip regions facing towards each other and with respective distal end regions of the core members being connected by a ferromagnetic bar member so as to form a closed magnetic circuit.

15. A method of applying forces to a ferromagnetic probe at a cellular or tissue level by means of a magnetic tweezer device according to one of claims 1 to 14, wherein an electrical current is driven through at least one solenoid member so as to generate a magnetic field interacting with a ferromagnetic probe embedded in a sample arranged on the sample support.

Fig. 1

Fig. 2

Fig. 3

Fig. 4

Fig. 5

Fig. 6

Fig. 7

Fig. 8a

Fig. 8b

Fig. 9a

Fig. 9b

Fig. 9c

Fig. 9d

Fig. 10

Comparison Saturation Curves

Fig. 11

Europäisches
Patentamt

European
Patent Office

Office européen
des brevets

# EUROPEAN SEARCH REPORT

Application Number

EP 18 15 6202

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | HOSU BASARAB G ET AL: "Magnetic tweezers for intracellular applications", REVIEW OF SCIENTIFIC INSTRUMENTS, AIP, MELVILLE, NY, US, vol. 74, no. 9, 1 September 2003 (2003-09-01), pages 4158-4163, XP012041048, ISSN: 0034-6748, DOI: 10.1063/1.1599066 * figures 1,2 * * paragraph [II.B] - paragraph [II.D] * | 1-15 | INV. B03C1/033 G01R33/12 G01N27/74 G01N11/10 |
| A,D | Monica Tanase ET AL: "Magnetic Tweezers in Cell Biology" In: "Cell Mechanics", 1 January 2007 (2007-01-01), Amsterdam [u.a.] : Elsevier, Acad. Press, c2007, NL, XP055492457, ISBN: 978-0-12-370500-6 vol. 83, pages 473-493, DOI: 10.1016/S0091-679X(07)83020-2, * figure 4 * * paragraph [000V] * | 1-15 | |
| A | WO 2013/041983 A1 (CENTRE NAT RECH SCIENT [FR]; VIOVY JEAN-LOUIS [FR]; MALAQUIN LAURENT []) 28 March 2013 (2013-03-28) * figures 12-14,15F * * page 33, line 5 - line 12 * | 1-15 | TECHNICAL FIELDS SEARCHED (IPC) B03C G01R G01N B25J |
| A | DE 197 45 807 A1 (BAUSCH ANDREAS M SC [DE]; SCHMIDT FRANK DIPL PHYS [DE]; SACKMANN ERICH) 6 May 1999 (1999-05-06) * figures 1,3,4 * * page 5, line 13 - page 6, line 2 * | 1-15 | |

The present search report has been drawn up for all claims

| Place of search | Date of completion of the search | Examiner |
|---|---|---|
| Berlin | 16 July 2018 | Polesello, Paolo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 18 15 6202

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2018

| Patent document cited in search report | | | Publication date | Patent family member(s) | | | Publication date |
|---|---|---|---|---|---|---|---|
| WO 2013041983 | A1 | | 28-03-2013 | CN | 103930210 | A | 16-07-2014 |
| | | | | EP | 2758173 | A1 | 30-07-2014 |
| | | | | US | 2014342373 | A1 | 20-11-2014 |
| | | | | WO | 2013041983 | A1 | 28-03-2013 |
| DE 19745807 | A1 | | 06-05-1999 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LIPFERT, J. ; HAO, X. ; DEKKER, N.H.** Quantitative Modeling and Optimization of Magnetic Tweezers. *Biophysical Journal,* 2009, vol. 96, 5040
- **DE VRIES, A.H.B. ; KRENN, B.E. ; VAN DRIEL,R. ; KANGER, J.S.** Micro Magnetic Tweezers for Nanomanipulation Inside Live Cells. *Biophysical Journal,* 2005, vol. 88, 2137
- **GOSSE, C. ; CROQUETTE, V.** Magnetic Tweezers: Micromanipulation and Force Measurement at the Molecular Level. *Biophysical Journal,* 2002, vol. 82, 3314
- Magnetic Tweezers for Single-Molecule Experiments. **VILFAN, I.D. ; LIPFERT, J. ; KOSTER, D.A. ; LEMAY, S.G. ; DEKKER, N.H.** Handbook of Single-Molecule Biophysics. 2009, 371
- **LIPFERT, J. ; KOSTER, D.A. ; VILFAN, I.D. ; HAGE, S. ; DEKKER, N.H.** Single-Molecule Magnetic Tweezers Studies of Type IB Topoisomerases. *Methods in Molecular Biology,* 2009, vol. 582, 71
- **KILINC, D ; LEE, G.U.** Advances in magnetic tweezers for single molecule and cell biophysics. *Integr. Biol.,* 2014, vol. 6, 27
- **SWAMINATHAN, V. ; MYTHREYE, K. ; O'BRIEN2, E.T. ; BERCHUCK, A. ; BLOBE, G.C. ; RICHARD SUPERFINE, R.** Mechanical Stiffness Grades Metastatic Potential in Patient Tumor Cells and in Cancer Cell Lines. *American Association for Cancer Research,* 2011, vol. 71 (15), 5045
- **KOLLMANNSBERGER, P. ; FABRY, B.** High-force magnetic tweezers with force feedback for biological applications. *Review of Scientific Instruments,* 2007, vol. 78, 114301
- **BAUSCH, A.R. ; MOLLER, W. ; SACKMANN, E.** Measurement of Local Viscoelasticity and Forces in Living Cells by Magnetic Tweezers. *Biophysical Journal,* 1999, vol. 76, 573

- **HOFFMAN, B.D. ; CROCKER, J.C.** Cell mechanics: Dissecting the Physical Responses of Cells to Force. *Annu. Rev. Biomed. Eng.,* 2009, vol. 11, 259
- **HOSU, B.G. ; JAKAB, K. ; BANKI, P. ; TOTH, F.I. ; FORGACS, G.** Magnetic tweezers for intracellular applications. *Review of Scinetific Instruments,* 2003, vol. 74, 9
- **YANG, Y. ; LIN, J. ; MESCHEWSKI, R. ; WATSON, E. ; VALENTINE, M.T.** Portable magnetic tweezers device enables visualization of the three-dimensional microscale deformation of soft biological materials. *Reports,* 2011, vol. 51 (11), 29
- **DESPRAT, N. ; WILLY SUPATTO, W. ; POUILLE, P.A. ; BEAUREPAIRE, E. ; FARGE, E.** Tissue Deformation Modulates Twist Expression to Determine Anterior Midgut Differentiation in Drosophila Embryos. *Developmental Cell,* 2008, vol. 15, 470
- **WEBER, G.F. ; MAUREEN A ; BJERKE, M.A. ; DESIMONE, D.W. A.** Mechanoresponsive Cadherin-Keratin Complex Directs Polarized Protrusive Behavior and Collective Cell Migration. *Dev Cell.,* 2012, vol. 17-22, 104
- **DOUBROVINSKIA, K. ; SWANA, M. ; POLYAKOVA, O. ; WIESCHAUSA, E.F.** Measurement of cortical elasticity in Drosophila melanogaster embryos using ferrofluids. *PNAS,* 2017, vol. 114, 1051
- **BIJAMOV, A. ; SHUBITIDZE,F. ; OLIVER,P.M. ; VEZENOV, D.V.** Quantitative modeling of forces in electromagnetic tweezers. *J. of App. Physics,* 2010, vol. 108, 104701
- Magnetic Tweezers in Cell Biology. **TANASE, M. ; BIAIS, N. ; SHEETZ, M.** Methods in Cell Biology. Elsevier, 2007, vol. 83, 473